# EUROPÄISCHE PATENTSCHRIFT

(11) **EP 0 616 720 B1**
(45) Veröffentlichungstag und Bekanntmachung des Hinweises auf die Patenterteilung: **08.05.1996**
(21) Anmeldenummer: 92919627.7
(22) Anmeldetag: 11.09.1992
(51) Int. Cl.: H01B 1/24, B29B 9/16, B01J 2/00

(54) **VERFAHREN ZUR HERSTELLUNG VON VERBUNDWERKSTOFFEN HOHER LEITFÄHIGKEIT MIT GERINGEN ANTEILEN AN ELEKTRONENLEITERN**
METHOD OF MANUFACTURING HIGHLY CONDUCTING COMPOSITES CONTAINING ONLY SMALL PROPORTIONS OF ELECTRON CONDUCTORS
PROCEDE DE FABRICATION DE MATERIAUX COMPOSITES A HAUTE CONDUCTIBILITE, COMPORTANT UN NOMBRE REDUIT DE CONDUCTEURS D'ELECTRONS

(30) Priorität: 11.12.1991 DE 4141416
(43) Veröffentlichungstag der Anmeldung: 28.09.1994
(73) Patentinhaber: ATOTECH Deutschland GmbH, D-10553 Berlin (DE)
(72) Erfinder: BESENHARD, Jürgen, Otto, D-44532 Horstmar (DE); MEYER, Heinrich, D-14109 Berlin (DE); CLAUSSEN, Olaf, D-48153 Münster (DE); KÜHLKAMP, Michael, D-48683 Ahaus (DE)
(74) Vertreter: Effert, Udo, Dipl.-Ing.
(86) Internationale Anmeldenummer: DE9200787
(87) Internationale Veröffentlichungsnummer: WO9312527

(56) Entgegenhaltungen:
- EP-A- 0 139 233
- EP-A- 0 400 544
- US-A- 2 683 669
- US-A- 4 233 191
- US-A- 4 874 477
- DATABASE WPI Section Ch, Week 7739, Derwent Publications Ltd., London, GB; Class A, AN 77-69523Y
- DATABASE WPIL Section Ch, Week 8909, Derwent Publications Ltd., London, GB; Class L, AN 89-065254
- DATABASE WPIL Section Ch, Week 8742, Derwent Publications Ltd., London, GB; Class A, AN 87-295891

## Beschreibung

Die Erfindung betrifft ein Verfahren zur Herstellung von elektrisch leitenden Verbundwerkstoffen aus überwiegend nichtleitenden oder wenig leitenden Stoffen, wobei die Leitfähigkeit durch ungewöhnlich geringe Anteile von zugefügten gut leitfähigen Materialien erreicht wird. Ein besonderes Merkmal der erfindungsgemäßen Verbundwerkstoffe ist die günstige räumliche Verteilung der zugefügten gutleitenden Materialien, die dadurch erreicht wird, daß Partikel der nichtleitenden oder wenig leitenden Stoffe vor der Herstellung der Verbundwerkstoffe mit hochdispersen Teilchen der leitfähigen Materialien umhüllt werden. Dies geschieht durch Behandeln der nichtleitenden bzw. wenig leitenden Partikel mit einer wäßrigen Lösung von Polymeren und anschließend mit einer tensidstabilisierten elektrolythaltigen Dispersion der gutleitenden Materialien.

Die Herstellung leitfähiger Verbundwerkstoffe aus überwiegend nichtleitenden Stoffen durch Zusatz leitfähiger Stoffe wird für viele Anwendungsbereiche angestrebt. Beispiele hierfür sind leitfähige und damit abschirmende Kunststoff-Gehäuse für elektronische Geräte oder etwa Batterieelektroden, die als elektrochemisch aktive Koponente wenig leitende Stoffe wie z.B. Braunstein enthalten.

Es gibt zahlreiche Studien, die sich mit der Abhängigkeit der Leitfähigkeit von leitfähige und nichtleitfähige Stoffe enthaltenden Verbundwerkstoffen beschäftigen. Die wichtigste Erkenntnis dieser Studien ist, daß die Leitfähigkeit des Verbundwerkstoffes keinesfalls proportional mit dem Zusatz der elektronenleitenden Komponente steigt, sondern daß erst nach Überschreiten eines meist recht hohen Schwellwerts des Anteils der leitfähigen Komponente auch die Leitfähigkeit des Verbundwerkstoffs ansteigt (siehe z.B. K.-J. Euler, R. Kirchhof, H. Metzendorf, J. Power Sources, 5 (1980) 255 und K. Aoki, J. Electroanal. Chem. 292 (1990) 53).

Die Ursache für diesen Effekt liegt darin, daß eine erhebliche Leitfähigkeit des Verbundwerkstoffes erst dann auftritt, wenn die leitende Komponente so dicht gepackt ist, daß ausgedehnte "Ketten" bzw. "Netze" der leitfähigen Teilchen entstehen, die für Leitfähigkeit über größere Entfernungen sorgen. Unter der Annahme gleichmäßig geformter Teilchen der leitfähigen bzw. der nichtleitfähigen Komponente läßt sich mit Hilfe der "Perkolationstheorie" die Leitfähigkeit von Mischungen der leitfähigen und der nicht leitfähigen Teilchen berechnen. Qualitativ läßt sich sagen, daß die Wahrschein-lichkeit, daß sich ausgedehnte Ketten bzw. Netze der leitfähigen Komponente bilden, erst bei sehr hohen Anteilen dieser Komponente ausreichend groß wird.

Innerhalb des Standes der Technik gibt es eine Reihe von Verfahren, die grundsätzlich eine leitende Beschichtung von Nichtleitern ermöglichen. Da sind zunächst jene Verfahren die im Vakuum durch Aufdampfen oder durch "Sputtern" (Kathodenstrahlzerstäubung) vor allem Metallschichten auf Nichtleiter aufbringen. Mit Hilfe der "Chemical Vapour Phase Deposition" (CVD) lassen sich ebenfalls zahlreiche Metalle und andere Stoffe auf Nichtleitern in dünner Schicht abscheiden.

Diesen Verfahren ist allerdings gemeinsam, daß sie zur Beschichtung von Pulvern, Fasern und dergleichen feinteiligen Materialien wenig geeignet sind, da eine allseitige Belegung feinteiliger Materialien deren dauer-nde Bewegung in der Gasphase bzw. im Vakuum erfordern würde. Wesentlich besser handhabbar für die Beschichtung großer Mengen kleiner Teilchen sind dagegen Beschichtungsverfahren aus Lösungen, wie z.B. die "außenstromlosen" Metallisierungsverfahren (C.R. Shipley Jr., Plating and Surface Finishing, 71 (1984) 92). Mit solchen außenstromlosen Verfahren gelingt vor allem die Metallisierung mit Kupfer, Nickel, Gold und Silber.

In der Druckschrift EP-A- 400 544 wird ein einstufiges Verfahren zur Herstellung leitfähiger Silikon-Kautschukpartikel beschrieben, in welchem die Beschichtung durch Vermischen von Silikon-Kautschukpartikeln, Ruß und Tensid in wässriger Lösung erfolgt. Die zur Beschichtung der Silikon-Kautschukpartikel benutzte Rußdispersion enthält zur Stabilisierung ein zusätzliches Netzmittel. Das Lösungsmittel muß durch Trocknen entfernt werden.

Die Rußteilchen lagern sich dabei durch Kontakt des Rußes mit den Kautschukpartikeln in der Dispersion durch **Adsorption** an diese an.

Aufgabe der vorliegenden Erfindung ist es, ein Verfahren bereitzustellen, bei dem ein Verbundwerkstoff mit hoher Leitfähigkeit in einfachster Art und Weise durch Anwendung der substratinduzierten Koagulation durch Implantierung von geringsten Mengen an leitfähigem Material herstellbar ist.

Gelöst wird diese Aufgabe durch die Lehre der Patentansprüche.

Das Verfahren zum Erzielen der substratinduzierten Koagulation erfordert es, daß die zu beschichtenden Körper in (a) eine wäßrige Lösung von Polymeren und anschließend bzw. nach einem Spülvorgang, in (b) eine mit Tensiden stabilisierte elektrolythaltige Dispersion der Teilchen mit denen beschichtet werden soll, getaucht werden. Es hat sich erwiesen, daß auf diese Weise z.B. mit Kohlenstoff belegte Nichtleiter anschließend galvanisch mit beliebigen Metallen belegt werden können.

Im Folgenden werden die Grundlagen und Merkmale der substratinduzierten Koagulation zusammenfassend dargestellt, da dieser Prozeß eine Vorstufe bei der Herstellung der erfindungsgemäßen Verbundstoffe hoher Leitfähigkeit ist. Außerdem wird der Prozeß der substratinduzierten Koagulation von konventionellen, mit Dispersionen von Beschichtungsmaterialien arbeitenden, Verfahren abgegrenzt. Im Rahmen der vorliegenden Erfindung wird die Belegung der nichtleitenden bzw. wenig leitenden Komponenten von Verbundwerkstoffen mit elektronenleitenden Materialien generell mittels der substratinduzierten Koagulation durchgeführt.

Die bisher gebräuchlichen Verfahren der Belegung von Oberflächen mit Feststoff-Partikeln beruhen auf zwei unterschiedlichen Haftprinzipien, nämlich a) der **Einbettung** der Teilchen in ein Bindemittel, das die Haftung auf der Substratoberfläche bewirkt und b) der **Adsorption** der Teilchen an der Substratoberfläche.

Die **Einbettung** ist das vorherrschende Prinzip bei der Anwendung höher viskoser, bindemittelhaltiger Dispersionen, während die **Adsorption** das wesentliche Haftungsprinzip bei der Anwendung niederviskoser und bindemittelarmer bzw. bindemittelfreier Dispersionen darstellt. Sofern die Feststoff-Partikel nur an der Oberfläche adsorbiert sind, bleibt die Menge der anhaftenden Feststoff-Teilchen gering - in der Regel bildet sich nur eine mehr oder weniger geschlossene Monolage der Teilchen. Bei der Adsorption von Kohlenstoff-Partikeln werden meist nur bräunlich aussehende Belegungen geringer elektrischer Leitfähigkeit erreicht.

Auch durch die Anwendung adsorptionsverstärkender Hilfsmittel, die z.B. durch entgegengesetzte elektrische Ladungen oder durch Dipol/Dipol- bzw. durch hydrophob/hydrophob-Wechselwirkungen die adsorptiven Kräfte verstärken, kann die **Dicke** der Belegung in der Regel, d.h. in Abwesenheit von Mehrfachadsorption, nicht den Grenzwert der Monolage überschreiten.

Im Gegensatz dazu können mit der substratinduzierten Koagulation dicke Belegungen erreicht werden. Die substratinduzierte Koagulation ist ein Prozess, der nicht nur zur Adsorption dispergierter Teilchen an Substratoberflächen, sondern zur lokalen **Koagulation** ausschließlich an der Substratoberfläche führt. Die Substratoberfläche muß dazu allerdings mit einem die Koagulation auslösenden Stoff belegt sein. Mit dieser substratinduzierten lokalen Koagulation können im Vergleich zur einfachen Adsorption sehr viel größere Mengen der Partikel gezielt an der Oberfläche abgeschieden werden.

Das Gelingen einer derartigen substratinduzierten lokalen Koagulation, die natürlich nicht in das Volumen der Dispersion fortschreiten darf, erfordert eine Reihe von Maßnahmen, die zunächst allgemein beschrieben werden sollen.

Ein wesentlicher Punkt für das Gelingen des Prozesses ist die Abstimmung der beiden Komponenten a) Koagulationsauslöser auf dem Substrat und b) koagulationsfähige Dispersion. Es handelt sich also um ein "2-Komponenten-Verfahren", bestehend auch 2 Lösungen, nämlich einer die koagulationsauslösende Komponente enthaltenden Vortauchlösung und eine darauf abgestimmte Dispersion der Feststoff-Partikel in einer niederviskosen Flüssigkeit.

Die Auslegung dieser Dispersion muß allerdings anders gestaltet sein, als die herkömmlicher Dispersionen, in denen durch reichliche Anwendung von Stabilisatoren die -normlerweise unerwünschte und häufig irreversible- Koagulation nach Möglichkeit verhindert wird.

Die Dispersionen für die Verwendung im Rahmen der substratinduzierten Koagulation sind "knapp" stabilisiert und vor allem durch dosierten Zusatz ausgewählter Elektrolyte nahe an den Koagulationspunkt gebracht. Eine sparsame Verwendung der Stabilisatoren-Tenside, die zur Erzielung guter Ergebnisse vorzugsweise anionisch oder kationisch geladen sein sollten- ist in der Regel nicht ausreichend, um Dispersionen aufzubauen, die dann in Kontakt mit einem geeigneten destabilisierenden Stoff spontan koagulieren.

Die Wahl der tensidischen Stabilisatoren, die das Ausflocken der Feststoff-Teilchen verhindern sollen, ist für das Funktionieren der substratinduzierten Koagulation nicht besonders kritisch. Nahezu alle bekannten Typen von Stabilisatoren sind im Prinzip geeignet, so daß z.B. auf die Verträglichkeiten mit den zu stabilisierenden Feststoff-Teilchen Rücksicht genommen werden kann.

Desgleichen stehen auch bei der Wahl der zur partiellen Destabilisierung der Dispersionen zuzusetzenden ionogenen Metallverbindung (Elektrolyte) vielfältige Auswahlmöglichkeiten offen. Gute Ergebnisse wurden mit KCl und NH₄NO₃ erhalten, aber auch CaCl₂ oder K₂SO₄ sind durchaus geeignet, wobei diese eher zufällig ausgewählten Beispiele keinesfalls beschränkend zu verstehen sind.

Typische Konzentrationen der Elektrolytzusätze liegen um 0.05 Mol/l, wobei jedoch je nach verwendetem Stabilisator auch wesentlich höhere oder niedrigere Konzentrationen zweckmäßig sein können.

Das am besten geeignete Lösungsmittel für diese Dispersionen ist Wasser, allerdings können, z.B. bei Benetzungsschwierigkeiten auf der Substratseite, als Zusatz zu Wasser oder auch ausschließlich, andere polare Lösungsmittel (z.B. Alkohole oder Ketone) eingesetzt werden.

Die Auswahl der feinteiligen Feststoffe, die nach dem Prinzip der substratinduzierten Koagulation auf Oberflächen niedergeschlagen werden können, ist nicht grundsätzlich beschränkt. Neben verschiedenen Kohlenstoff-Materialien lassen sich beispielsweise -aber keinesfalls einschränkend- auch feinteilige Oxide wie Kieselsäure (SiO₂), Wolframblau (H_{X}WO₃), oder Schichtverbindungen wie MoS₂ substratinduziert koagulieren.

Um eine Koagulation ausschließlich oder überwiegend im Volumen der Dispersion -und damit ihre Zerstörung- zu vermeiden, muß der die Koagulation auslösende Stoff an der Substratoberfläche haften bleiben. Dies kann insbesondere durch polymere Koagulationsauslöser erfolgen, die von der Oberfläche zumindest nur sehr langsam abgelöst werden können, wodurch ein möglicher Ablöseprozess von der einsetzenden Koagulation "überholt" wird.

Außerdem bedecken solche Makromoleküle in der Regel weitaus weniger Oberfläche, als man es aufgrund ihrer Abmessungen erwarten würde. Vielmehr ragen oft erhebliche Anteile der Moleküle in Form von "Schleifen" oder "Tentakeln" ins Lösungsinnere, wodurch eine/ gegenüber kleinen Molekülen mit ansonsten ähnlichen Eigenschaften, drastisch erhöhte "Reichweite" ihrer Wirksamkeit bedingt ist.

Als geeignet für eine koagulationsauslösende Vorbehandlung von Substraten für eine substratinduzierte Koagulation hat sich eine große Zahl von wasserlöslichen Polymeren erwiesen, wobei offensichtlich das Vorhandensein oder das Vorzeichen einer Ladung keine besonders entscheidende Rolle spielt. Gute Ergebnisse wurden mit allen Sorten von Gelatine erzielt, ebenso mit Polyacrylaten, die zur Verbesserung ihrer Löslichkeit eine gewisse Anzahl von Ammoniumgruppen trugen (z.B. Basoplast-Typen der BASF). Geeignet sind auch andere wasserlösliche Peptide wie z.B. die Albumine.

Neben den genannten -in der Regel eine eine geringe kationische Ladungsdichte tragenden- hochmolekularen Stoffen sind auch noch zahlreiche weitere kationisch geladene Polyelektrolyte als Koagulationsauslöser sehr gut geeignet, z.B. Co-polymerisate des Acrylamids oder Methacrylamids mit Salzen oder Quarternisierungsprodukten von Aminoacrylaten oder andere Polyelektrolyte, die einfache oder substituierte Ammoniumgruppen tragen. Zahlreiche Verbindungen dieser Art sind als "Flockungsmittel" im Handel und tragen Bezeichnungen wie z.B. Superfloc (American Cyanamid), Etadurin (Akzo), Sedipur (BASF), Magnafloc (Allied Colloids), Nalcolyte (Nalco), Sanfloc (Sanyo) oder Separan (Dow Chemical).

Es wurde überraschend gefunden, daß sich dabei die kationischen Polyelektrolyte mit relativ geringer Ladungsdicht (< 0.5 meq/g) als bessere Koagulationsauslöser als die mit höherer Ladungsdichte erweisen. Dies ist ein Hinweis dafür, daß nicht einfach elektrostatische Wechselwirkungen zwischen der "kationischen Oberfläche" und anionisch stabilisierten Feststoff-Partikeln für deren Haftung verantwortlich sind.

Es ist aber keinesfalls so, daß nur kationische geladene hochmolekulare Stoffe als Koagulationsauslöser geeignet sind. Mit einer Reihe von ungeladenen wasserlöslichen Makromolekülen, so z.B. mit Polyacrylamiden, mit Polyvinylpyrrolidonen oder mit Polyvinylalkoholen (z.B. Mowiol-Typen der Fa. Hoechst) nicht zu geringer durchschnittlicher Molmasse vorzugsweise > 10 000 U) lassen sich Ergebnisse erhalten, die mit denen von kationischen Polyelektrolyten vergleichbar sind. Andere geeignete ungeladene Makromoleküle sind z.B. Polyethylenglykole und Polyethylenglykolether. Epichlorhydrin-Imidazol-Adukte, Polyvinylimidazole, außerdem Polysaccharide wie Agar-Agar, Stärke, Pektine oder Dextrane und kerpolymere, wie z.B. Alginsäuren.

Schließlich kann auch mit anionisch geladenen hochmolekularen Stoffen eine koagulationsauslösende Wirkung erzielt werden. Beispiele hierfür sind das Na-Salz der Carboxymethylcellulose oder das Na-Salz der "Alginsäure", einem Mischpolymerisat der Mannuron- und Glucuronsäure. Andere geeignete anionisch geladene hochmolekulare Stoffe sind z.B. Alakalisalze der Polycarbonsäuren wie z.B. der Polyacrylsäure oder anderer Säuren, wie z.B. der Polyvinylphosphorsäure.

Ein Beweis dafür, daß der Effekt der substratinduzierten Koagulation nicht in einfacher Weise mit der trivialen elektrostatischen Anziehung entgegengesetzter Teilchen zu erklären ist, ist die Tatsache, daß z.B. mit **kationischen** Koagulationsauslösern wie Gelatine bei einem pH-Wert um 3.2 in Kombination mit **kationisch** stabilisierten Feststoff-Partikeln eine Koagulation herbeigeführt werden kann. In ganz ähnlicher Weise können mit **anionischen** Koagulationsauslösern wie Alginat oder Carboxymethylzellulose-Na-Salz auch **anionisch** stabilisierte Feststoff-Partikel an Substraten koaguliert werden.

Bei dieser Sachlage ist es auch nicht mehr erstaunlich, daß mit **ladungsneutralen** Koagulationsaulösern ebenfalls **anionisch** und **kationisch** stabilisierte Feststoff-Partikel an Substraten koaguliert werden können.

Das Verfahren der substratinduzierten Koagulation ist demnach im Hinblick auf die Eigenschaften des zu beschichtenden Materials wenig differenzierend, d.h. es können praktisch alle Materialien auf diese Weise beschichtet werden. Tatsächlich spielt das Material des Substrates keine entscheidende "chemische Rolle" beim Koagulationsvorgang. Die einzige Voraussetzung, die für das Gelingen des Vorgangs erfüllt sein muß, ist eine ausreichende Belegung der Substratoberfläche mit einem Koagulationsauslöser.

Diese Voraussetzung kann mit wasserlöslichen Polymeren auf praktisch allen Substraten erfüllt werden. Selbst das hydrophobe wie lipophobe PTFE (Teflon) behält nach dem Tauchen in wäßrige Lösungen des Koagulationsaulösers Gelatine - selbst nach anschließender Spülung mit Wasser- noch genügende Mengen des koagulationsauslösenden Stoffes an seiner Oberfläche, so daß es sich beim Eintauchen in erfindungsgemäße Ruß-Dispersionen mit einer dichten Ruß-Schicht überzieht.

Andere Kunststoffe, etwa polare wie Epoxide, Polyamide, Polyimide, Phenolharze, ABS-Kunststoff oder unpolare wie Polyethylen und Polypropylen lassen sich ebenso wie Metalle oder Glas und Keramik mit Feststoff-Partikeln belegen.

Sofern eine **regioselektive** Belegung gewünscht wird, kann dies durch entsprechende Masken schon beim Tauchen in die Polymerlösung erreicht werden. Bereiche, die hier abgedeckt waren, werden beim zweiten Tauchschritt nicht von koagulierten Partikeln bedeckt. In bestimmten Fällen ist es auch möglich, **substratselektive** Belegungen zu erreichen. Wegen der geringen Substratspezifik des Koagulationsprozesses ist dies allerdings nur durch Nachbehandlungen realisierbar.

Die bei der substratinduzierten Koagulation ablaufenden Einzelschritte, sind noch nicht abschließend aufgeklärt und noch nicht auf ihre Allgemeingültigkeit überpüft. Nach dem derzeitigen Stand unserer Erkenntnis bewirken wasserlösliche -und damit polare- Polymere auf der Oberfläche der mit Feststoff-partikeln zu belegenden Substrate, daß sich die in der Dispersion befindlichen Stabilisatoren -grenzflächenaktive Substanzen, die die Feststoff-Partikel hydrophilieren und damit "schwimmfähig" machen- teilweise von der Partikeln ablösen und mit den Polymeren direkt wechselwirken. Damit verlieren die besonders nahe an der Oberfläche des Substrates befindlichen Feststoff-Partikel ihre "Schwimmfähigkeit" und koagulieren auf dieser Oberfläche.

Es ist überraschend und bemerkenswert, daß der Mechanismus der dieser Erfindung zugrundeliegenden substratinduzierten Koagulation nicht in trivialer Weise als Wechselwirkung zwischen entgegengesetzten Ladungen auf der Substratoberfläche (bewirkt z.B. durch ein positive Ladungen tragendes adsorbiertes Polymer) und auf den Feststoff-partikeln (bewirkt z.B. durch ein negative Ladungen tragendes anionisches Tensid) aufzufassen ist.

Zahlreiche Beispiele belegen, daß eine substratinduzierte Koagulation auch dann erfolgen kann, wenn die Substratoberfläche und die suspendierten Partikel gleichsinnig geladen oder auch praktisch ungeladen sind.

Tatsächlich konnte mit nahezu allen Kombination von Substratbelegungen (kationische, anionisch und neutrale Polymere) und Stabilisatoren für die suspendierten Teilchen (kationische, anionische und ambivalente Tenside) der Effekt der substratinduzierten Koagulation grundsätzlich beobachtet werden - wenn auch nicht immer mit guten Ergebnissen. Insbesondere zur Stabilisierung der Feststoff-Disperionen haben sich geladene Tenside besser bewährt als ungeladene.

Die geringe Bedeutung der Ladung der auf den Substraten adsorbierten Polymeren wird auch dadurch belegt, daß bei einer Kombination von kationischen Polymeren (Polyelektrolyte auf der Basis von Acrylamid) und anionisch (Aerosol OT, Cyanamid) stabilisierten Ruß-Dispersionen (Furnaceruß Printex L.6, Degussa) z.B. auf Epoxid-Oberlächen höhere Rußbelegungen mit abnehmender Ladungsdichte der kationischen Polymeren gefunden werden.

Ein entscheidender Vorteil **hochmolekularer** Koagulationsauslöser im Vergleich zu niedermolekularen ist deren bessere Haftung auf der Substratoberfläche, die schon rein statistisch durch die große Zahl möglicher Koordinationsstellen gegeben ist.

Außerdem ragen hochmoleklare.an Oberflächen adsorbierte Substanzen mit "Schleifen" und "Tentakeln" weit in die Lösung hinein, so daß ihre Wirkung nicht nur auf die unmittelbare Oberfläche beschränkt ist.

Ein wesentlicher Bestandteil der für eine substratinduzierte Koagulation geeigneten "knapp" stabilisierten Dispersionen ist ihr Elektrolytgehalt. Mit zunehmendem Elektrolytgehalt nimmt die Stabilität von kolloiden Dispersionen ab, bis schließlich eine kritische Koagulationskonzentration erreicht wird. (J. Gregory, Material Science Forum, 25/26 (1988) 125). Die für die "knappe" Einstellung der Dispersionen geeigneten Elektrolytkonzentrationen müssen experimentell ermittelt werden, wobei die Wahl der Elektrolyte nicht besonders kritisch ist. Wichtig ist, daß die Dispersion einerseits nahe genug an die Flockungsgrenze herangebracht wird, wobei andererseits eine hinreichende Stabilität noch gewährleistet sein muß.

Besonders überraschend ist es, daß mit Dispersionen, die durch Elektrolytzusätze bewußt nahe an ihre Koagulationsgrenze gebracht werden, ein technisch sicher und gut beherrschbarer Prozess durchgeführt werden kann. Die Stabilitätsfenster lassen sich aber in der Praxis ohne weiteres so setzen, daß einerseits die elektrolythaltigen Dispersionen noch haltbar sind, andererseits aber in Kontakt mit den Koagulationsauslösern spontane Koagulation erfolgt.

Es wurde schon oben ausgeführt, daß mit dem Verfahren der substracinduziarten Koagulation wesentlich **dickere** Schichten von Festkörper-Partikeln niedergeschlagen werden können, als es mit auf einfacher Adsorption beruhenden Vefahren möglich ist.

Damit verbunden ist, z.B. die höhere Leitfähigkeit von Beschichtungen aus elektronenleitenden Partikeln. Weiterhin ist das erfindungsgemäße Verfahren der substratinduzierten Koagulation auf allen Oberflächen, z.B. polaren und auch unpolaren Kunststoffen (wie etwa Polypropylen oder Teflon) und auch auf Metallen oder Gläsern anwendbar.

Zu erwähnen bleibt noch, daß die substratinduzierte Koagulation ein in der Regel irreversibler Prozeß ist und demzufolge die einmal niedergeschlagenen Feststoff-Partikel ausreichend haften, um einen unmittelbar anschließenden Spülvorgang zu widerstehen. Solche Spülvorgänge sind in der Technik zum Vermeiden von "Verschleppungen" bei der aufeinanderfolgenden Anwendung verschiedener Bäder unumgänglich.

Ein weiterer Vorteil der mit der irreversiblen Koagulation verbundenen "Spülfestigkeit" der Schichten aus Feststoff-Partikeln liegt in der **Wiederholbarkeit** des Vorgangs, mit dem Ziel, besonders **dicke** Schichten aufzubauen. So können z.B. mit den Lösungen: A = Vortauchlösung mit Gelatine, B = Spülwasser, C = Dispersion von kationisch stabilisiertem Ruß mit Zusatz von KCl) durch eine Tauchfolge A-B-C-B-A-B-C-B-A-B-C ... sukzessive dicke Rußschichten auf den Substraten aufgebaut werden.

Der Prozeß der substratinduzierten Koagulation zeichnet sich auch dadurch aus, daß er mit Stoffen arbeitet, von denen keinerlei Gefahren für die Umwelt bzw. für die Gesundheit ausgehen. Die polymeren Koagulationsauslöser sind zum großen Teil buchstäblich "eßbar" und werden in der Lebensmitteltechnologie verbreitet eingesetzt (z.B. Gelatine und Carboxymethylzellulose). Auch die Ungefährlichkeit der tensidischen Stabilisatoren für die feinteiligen Stoffe ist in den meisten Flällen durch langjährigen problemlosen Gebrauch (z.B. in Körperpflegemitteln) erwiesen. Außerdem kommt der Prozeß ohne organische Lösungsmittel aus.

Bei der Herstellung leitfähiger Verbundwerkstoffe aus überwiegend nichtmetallischen Stoffen ist man bestrebt, mit möglichst **geringen** Mengen der leitfähigen Zusätze auszukommen, da durch sie erwünschte Eigenschaften des nicht oder wenig leitenden Stoffes verschlechtert werden. So erniedrigt sich z.B. bei Kunststoffen durch den Zusatz von leitfähigen Rußen die Schlagzähigkeit. Bei Batterieelektroden sinkt durch solche Zusätze, die zwangsläufig den Anteil der elektrochemisch aktiven Komponenten verringern, die Energiedichte.

Eine zum Erzielen hoher Leitfähigkeiten besonders günstige Verteilung der leitfähigen Komponente in Verbundwerkstoffen ist dadurch zu erreichen, daß die nichtleitenden Teilchen mit einer dünnen Schicht eines leitfähigen Materials überzogen und anschließend z.B. durch Sintern, Pressen oder Verkleben zu Formkörpern verarbeitet werden. Problematisch ist allerdings die technische Umsetzung diese Prinzips, weil dazu ein leistungsfähiges Verfahren zur leitenden Beschichtung großer Mengen kleiner Teilchen von nichtleitenden Stoffen erforderlich ist.

Die erfindungsgemäßen Verbundwerkstoffe hoher Leitfähigkeit werden aus nicht leitenden oder wenig leitenden Partikeln hergestellt, die unter Nutzung des Verfahrens der substratinduzierten Koagulation mit hochdispersen leitenden Feststoffen umhüllend belegt werden.

Innerhalb dieses Verfahrens bestehen noch verschiedene Optionen. So kann in bestimmten Fällen, insbesondere bei faserigen Nichtleitern bzw. daraus gefertigten, gewebten oder nicht gewebten, textilartigen Produkten auf den nachfolgenden Verdichtungsvorgang (Verpressen, Sintern oder Verkleben) verzichtet werden. Außerdem kann die durch die substratinduzierte Koagulation von leitenden Partikel erzeugte oberflächenleitfähigkeit genutzt werden, um mit galvanischen Verfahren weitere leitende Überzüge aufzubringen. Hierzu eignen sich insbesondere elektrochemische "Wirbelschichreaktoren", die elektrochemische Reaktionen an kleinen leitenden Partikeln erlauben.

Die Option der wiederholten Belegung mittels substratinduzierter Koagulation kann schließlich nicht nur zur Erzeugung besonders dicker, sondern -bei Variation der Dispersionslösung- auch zur Erzeugung "gemischter" Belegungen genutzt werden.

Die zur Herstellung von Verbundwerkstoffen hoher Leitfähigkeit erforderlichen leitend beschichteten Partikel aus thermoplastischen Materialien können natürlich grundsätzlich auch mit anderen Beschichtungsverfahren hergestellt werden. Eine mögliche, wenngleich relativ aufwendige Alternative ist das oben erwähnte "außenstromlose" Matallisieren.

Der drastische Vorteil der Verwendung leitend umhüllter thermoplastischer Partikel als Ausgangsprodukt für die Herstellung von Verbundwerkstoffen wird durch das Ausführungsbeispiel (1) demonstriert, in dem Leitfähigkeiten unterschiedlich hergestellter Verbundwerkstoffe mit praktisch gleichen Gehalten an elektronenleitenden Stoffen verglichen werden.
Die erfindungsgemäßen Verbundwerkstoffe können vielfältige Anwendungen finden. So können z.B. mit Kohlenstoff umhüllend belegte Polypropylen-Pulver zu elektrisch leitenden Formkörpern wie Gehäusen für elektronische Geräte verarbeitet werden. Auch in elektrochemischen Reaktoren sind Materialien mit den mechanischen Eigenschaften von Kunststoffen und gleichzeitig hoher elektronischer Leitfähigkeit vielfältig verwendbar, z.B. für die Fertigung von Stütz- und Ableit-Gittern für größere Batterieelektroden. Ein besonderer Vorteil liegt dabei in der im Vergleich zu Metallen sehr viel einfacheren Formgebung.

Mit Kohlenstoff umhülltes Polypropylen- oder PTFE-Pulver eignet sich hervorragend als leitender Binder für die Herstellung von Batterieelektroden, die z.B. Braunstein-Pulver oder andere feinteilige spröde Feststoffe enthalten. Besonders gute Ergebnisse werden dabei erzielt, wenn die Partikel des spröden Feststoffes ebenfalls nach dem Prinzip der substratinduzierten Koagulation mit hochdispersen Elektronenleitern belegt werden.

### Beispiele

Die Erfindung soll anhand der folgenden Beispiele näher erläutert werden, ohne daß darin eine Einschränkung zu sehen ist.

### Beispiel 1

Ausgegangen wird von Polypropylenpulver für die Chromatographie (Katalog-Nr. 4342) der Firma Polysciences, Inc., Warrington mit einem mittleren Korndurchmesser von etwa 35 µm. Dieses Pulver wird zur Vorbereitung mit der Vortauchlösung Neoganth^{R} B der Firma Schering Galvanotechnik behandelt. Angesetzt und gehandhabt wird die Lösung nach der Gebrauchsanweisung. Lediglich die Einwirkzeit wird auf 5 min verlängert. Der Ansatz sollte bei 10 g Pulver pro Liter Lösung liegen und intensiv gerührt werden. Anschließend wird das Polypropylenpulver in einem entsprechenden Filtertiegel abgesaugt und ohne Spülung und Lagerung sofort weiter verwendet.

Das vorbehandelte Pulver wird nun mit der Aktivatorlösung Neoganth^{R} der Firma Schering Galvanotechnik behandelt. Angesetzt und gehandhabt wird die Lösung nach der Gebrauchsanweisung. Lediglich die Behandlungsdauer wird auf 15 min erhöht. Nun wird in einem entsprechenden Filtertiegel abgesaugt und anschließend das Pulver in dest. Wasser aufgeschlämmt und wieder abgesaugt. Diese Aufschlämmung wird einmal wiederholt. Das so behandelte Material wird sofort und ohne Lagerung reduziert. Für Ansatzmenge und Rührung gilt das bei der Vortauchlösung gesagte.

Reduziert wird das mit Aktivator beladene Pulver mit einer Lösung aus 4 g Natriumhydroxid und 1 g Natriumborhydrid pro Liter dest. Wasser. Die Lösung wird jeweils frisch angesetzt. Die Badtemperatur beträgt 20 - 25 ° C bei einer Behandlungsdauer von 6 min. Anschließend wird auf einem entsprechenden Filtertiegel abgesaugt und in dest. Wasser aufgeschlämmt. Nach kurzem Stehenlassen wird das aufgeschwommene Polypropylenpulver mit Hilfe einer Schöpfkelle abgeschöpft.

Aktiviertes Polypropylenpulver wird mit dem chemischen Kupferbad Noviganth® HC der Firma Schering Galvanotechnik verkupfert. Angesetzt und gehandhabt wird das Bad nach Gebrauchsanweisung. Die Verkupferung erfolgt mit einem Ansatz von 2 g Pulver pro Liter Kupferbad unter Argon als Schutzgas. Entgegen der Betriebsanleitung des Bades werden die Badparameter bezüglich des Kupfers nicht kontrolliert. Den gewünschten Kupferanteil auf dem Pulver erhält man durch Abbrechen des Versuchs nach in Vorversuchen ermittelten Zeiten oder durch ständige Analyse von Proben während der Verkupferung. Anschließend wird das verkupferte Pulver auf einem Filtertiegel abgesaugt und zur Entfernung von Badresten in dest. Wasser aufgeschlämmt und wieder abgesaugt. Dieser Reinigungsvorgang wird einmal wiederholt. Nun trocknet man das Pulver im Vakuum. Jetzt kann das Pulver entweder sofort weiter verwendet oder unter Argon gelagert werden.

Das verkupferte Pulver wird nun zu Formkörpern - hier zu Tabletten für weitere Messungen - verarbeitet. Dies geschieht in einem geeigneten Preßwerkzeug. Hierzu bringt man die gewünschte Menge Pulver in das Werkzeug ein. Jetzt wird das Pulver langsam und schrittweise innerhalb von 30 min bis zum maximal für das Werkzeug zulässigen Preßdruck gepreßt (mindestens 2 t/cm). Ist der Druck erreicht, wird er für weitere 20 min konstant gehalten. Die Angaben der Preßzeiten beziehen sich lediglich auf das verwendete Preßwerkzeug und können, insbesondere durch Verwendung von vakuumtauglichen Werkzeugen, drastisch verringert werden.

Das gepreßte Polypropylenpulver wird mitsamt dem Preßwerkzeug bei arretiertem Stempel in einen auf 210 °C vorgeheizten Ofen gebracht und nach 30 min wieder entnommen. Nach Abkühlung auf Raumtemperatur kann die massive Tablette entnommen werden.

Diese Tablette wird nun an den Stirnflächen angeschliffen, um eventuelle oberflächliche Oxide zu entfernen und auf diesen Flächen mit Leitsilber versehen. Nach dem Trocknen des Leitsilbers wird der Widerstand der Tablette gemessen. Aus den geometrischen Daten der Tablette und dem gemessenen Widerstand läßt sich nun der spezifische Widerstand errechnen. Er beträgt für eine Tablette aus stromlos verkupfertem Polypropylenpulver bei einem Gehalt von 24 Gew.-% Kupfer 5 Ω·cm.

Als Vergleich werden aus dem oben genannten Polypropylenpulver und Kupferpulver der Firma W.C. Heraeus GmbH, Hansu (Typ 000-05, Ch. 883031) ebenfalls Tabletten hergestellt. Hierzu mischt man jeweils genau eingewogene Mengen Kupferpulver und Polypropylen-pulver durch Rühren und Verreiben in einem Mörser bis zur völligen Homogenität. Zur Verhinderung der Oxidation des Kupferpulvers wird unter Argon gearbeitet. Die weitere Verarbeitung erfolgt entsprechend dem stromlos verkupferten Polypropylenpulver. Es ergeben sich spezifische Widerstände von > 50 MΩ·cm (27 Gew.-% Kupfer), > 50 MΩ·cm (33 Gew.-% Kupfer), > 50 MΩ·cm (39 Gew.-% Kupfer), 176 kΩ·cm (48 Gew.-% Kupfer).

### Beispiel 2

Ausgegangen wird von Teflon® - Pulver mit einem mittleren Korndurchmesser von etwa 300 µm (Firma Roth; Katalog-Nr. 5603.1). Dieses Pulver wird im folgenden mit Kohlenstoff (Ruß Printex® L6; Firma Degussa) leitend beschichtet. Die hier eingesetzte Rußdispersion hat folgende Zusammensetzung:
- Tensid: 3,2 . 10⁻³ M Hexadecyltrimethylammoniumbromid (Firma Aldrich; Katalog-Nr. 85,582-0)
- Elektolyt: 0,05 M KCl
- Ruß: 1% Printex® L6
Als Lösungsmittel dient deionisiertes Wasser.

Bei der Herstellung der Dispersion wird zunächst das Tensid durch Zusatz der gleichen Gewichtsmenge Ethanol gelöst und in Wasser vorgelegt. Anschließend wird der Ruß eingerührt und 15 min mit Ultraschall dispergiert und abschließend wird der Elektrolyt in Form einer 1 molaren Lösung unter Rühren zugegeben, die Dispersion auf das Endvolumen aufgefüllt und nochmals 5 min beschallt. Während des Gebrauchs wird nach ein bis zwei Tagen eine wiederholte Ultraschalldispergierung notwendig.

Ebenfalls zum Einsatz kommt eine 0,2 %ige wässrige Gelatinelösung. Zur Herstellung der Lösung wird die Gelatine (mittlere Gelstärke; Firma Fluka; Katalog-Nr. 48722) nach 10 min Quellen zunächst bei 60° C gelöst, anschließend wird 5 h bei 7° C gelagert und danach auf 20° C erwärmt.

Die folgenden Proben sollen deutlich machen, daß der Einsatz von Gelatine bei der Belegung von Tefon®-Pulver mit Ruß zu einer verstärkten Abscheidung führt.
- Probe 1: Um das hydrophobe Teflon®-Pulver in der wässrigen Rußdispersion besser handhaben zu können, wird es zuerst mit einem Tensid benetzt. Dazu wird das Pulver 2 min in einer 1 %igen Tensidlösung (Aerosol® OT-100; Firma Cyanamid; Katalog-Nr. 16253) gerührt (bei RT). Nun wird das benetzte Teflon® abgesaugt, zur Reinigung mehrfach in Wasser aufgeschlämmt und wieder abgesaugt. Das so behandelte Material wird dann unter Rühren 2 min zu einer 0,2 %igen wässrigen Gelatinelösung gegeben (bei 20° C). Danach wird das Teflon®-Pulver erneut aufgeschlämmt und abgesaugt. Als nächster Schritt wird das Pulver 5 min unter Rühren zu der Rußdispersion gegeben (bei 30° C). Anschließend wird das beschichtete Pulver 1 h bei 120° C getrocknet.
- Probe 2: Im Gegensatz zu Probe 1 wird hier der Arbeitsschritt mit der Gelatine-Lösung nicht durchgeführt. Die übrigen Prozeßabschnitte werden analog zu Probe 1 durchgeführt.
- Probe 3: Bei dieser Probe wird das Teflon® mit einem Gemisch aus Aerosol®-Lösung (1% Konzentration) und Gelatine-Lösung (0,2% Konzentration) im Verhältnis 1:1 unter Rühren behandelt (10 min bei RT). Danach wird abgesaugt, mit Wasser mehrfach aufgeschlämmt und wieder abgesaugt. Anschließend wird das Pulver 1 h unter Rühren in die Rußdispersion gegeben (bei 30° C). Danach wird erneut abgesaugt, aufgeschlämmt und abgesaugt. Abschließend wird das Teflon® 1 h bei 120° C getrocknet.
- Probe 4: im Gegensatz zu Probe 3 wird hier ohne Gelatine gearbeitet. Das Teflon® Pulver wird zunächst mit der 1%igen Aerosol®-Lösung benetzt (10 min bei RT). Danach wird abgesaugt, mehrfach mit Wasser aufgeschlämmt und wieder abgesaugt. Die anschließende Belegung mit Ruß und der Trocknungsvorgang entsprechen denen bei Probe 3.

Um die Belegung des Teflonpulvers mit Ruß zu überprüfen, wird von jeder Probe bei einem Druck von 20 kp/cm eine Tablette gepreßt. Auf den Stirnflächen dieser Tabletten wird dann Leitsilber aufgetragen. Aus den geometrischen Daten der Tabletten und dem gemessenen Widerstand läßt sich nun der spezifische Widerstand berechnen: Probe 1 = 370 Ω·cm, Probe 2 = 780 Ω·cm und Probe 3 = 84 Ω·cm, Probe 4 = 414 Ω·cm.

### Beispiel 3

Dieses Beispiel zeigt, daß eine Mehrfachbeschichtung zu deutlich besseren Ergebnissen führt.
- Probe 5: Bei dieser Probe wird zunächst das Teflon®-Pulver benetzt (vergl. Probe 1). Danach wird abgesaugt, mehrfach mit Wasser aufgeschlämmt und wieder abgesaugt. Die nun folgenden Arbeitsschritte (Behandlung mit Gelatine, Reinigung durch Aufschlämmung und Belegung mit Ruß) sind identisch mit denen bei Probe 1. Im Gegensatz zu 1 wird nun jedoch nicht getrocknet, sondern die eben angesprochenen Arbeitsschritte (Gelatine, Reinung und Ruß) werden noch jeweils 2 x wiederholt. Erst dann wird nach erneuter Aufschlämmung und Absaugung analog zu Probe 1 getrocknet.

Zur Überprüfung der Qualität der Belegung des Teflon®-Pulvers mit Ruß wird hier ebenfalls die Probe zu einer Tablette verarbeitet (vergl. Bsp.1). Der Widerstand beträgt: Probe 5 = 31Ω· cm.

## Patentansprüche

1. Verfahren zur Herstellung von Verbundwerkstoffen hoher Leitfähigkeit, gekennzeichnet durch die Verfahrensschritte
a) Kontaktieren eines Pulvers oder von Fasern mit einer wäßrigen Lösung, enthaltend eine makromolekulare, merklich wasserlösliche Substanz,
b) gegebenenfalls Spülen mit Wasser,
c) Kontaktieren mit einer Dispersion, enthaltend leitfähige, feinteilige Feststoffpartikel, Netzmittel(Tenside) und eine ionogene Metallverbindung,
d) gegebenenfalls Spülen mit Wasser und
e) Formgebung.

2. Verfahren nach Anspruch 1, dadurch gekennzeichnet, daß die leitend umhüllten Partikel einer Formgebung oder Verdichtung durch Pressen, Sintern und/oder Zusatz von Klebern oder plastischen Bindemitteln unterzogen werden.

3. Verfahren nach Anspruch 1 oder 2, dadurch gekennzeichnet, daß die mittels substratinduzierter Koagulation leitend gemachten Partikel ganz oder teilweise thermoplastischer Natur sind.

4. Verfahren gemäß Anspruch 1, wobei als leitfähige Partikel Graphit und/oder Ruß verwendet werden.

5. Verfahren gemäß Anspruch 1, wobei als Netzmittel anionische oder kationische Tenside oder Phasentransfer-Katalysatoren verwendet werden.

6. Verfahren gemäß Anspruch 1, wobei als ionogene Metallverbindungen Fluoride, Chloride, Bromide oder Jodide des Lithiums, Natriums, Kaliums, Magnesiums, Calciums, Bariums, Strontiums, Ammoniums oder Kupfers verwendet werden.

7. Verbundwerkstoff hoher Leitfähigkeit, hergestellt nach einem Verfahren gemäß Anspruch 1 und 2, dadurch gekennzeichnet, daß die mittels "substratinduzierter Koagulation" leitend gewordenen Partikel nach der Formgebung durch galvanische oder chemische reduktive Verfahren weiter metallisiert werden.

## Claims

1. Method of producing composite materials of high conductivity, characterised by the method steps
a) contacting a powder or fibres with an aqueous solution, containing a macromolecular, considerably water-soluble substance,
b) if necessary, rinsing with water,
c) contacting with a dispersion, containing conductive, finely divided solid particles, wetting agents (surfactants) and an ionogenic metal compound,
d) if necessary, rinsing with water, and
e) form-shaping.

2. Method according to claim 1, characterised in that the conductively coated particles are subjected to a form-shaping or compacting process by pressing, sintering and/or adding adhesives or plastic bonding agents.

3. Method according to claim 1 or 2, characterised in that the particles, which are made conductive by means of substrate-induced coagulation, are wholly or partially of a thermoplastic nature.

4. Method according to claim 1, wherein graphite and/or carbon black are used as the conductive particles.

5. Method according to claim 1, wherein anionic or cationic surfactants or phase-transfer catalysts are used as the wetting agents.

6. Method according to claim 1, wherein fluorides, chlorides, bromides or iodides of lithium, sodium, potassium, magnesium, calcium, barium, strontium, ammonium or copper are used as the ionogenic metal compounds.

7. Composite material of high conductivity, produced in accordance with a method according to claims 1 and 2, characterised in that, after the form-shaping process, the particles which have become conductive by means of "substrate-induced coagulation" are further metallised by galvanic or chemical reductive processes.

## Revendications

1. Procédé de fabrication de matériaux composites à bonne conductibilité, caractérisé par les étapes du procédé suivantes :
a) mise en contact d'une poudre ou de fibres avec une solution 10 aqueuse, contenant une substance macromoléculaire nettement soluble à l'eau,
b) le cas échéant, lavage à l'eau,
c) mise en contact avec une dispersion contenant de fines particules solides conductrices, un agent de mouillage (agents tensioactifs) et une liaison métallique ionogène,
d) le cas échéant, lavage à l'eau et
e) mise en forme.

2. Procédé selon la revendication 1, caractérisé en ce que les 20 particules enrobées de conducteurs sont soumises à une mise en forme ou une densification par compactage, frittage et/ou addition de colles ou liants plastiques.

3. Procédé selon la revendication 1 ou 2, caractérisé en ce que les particules rendues conductrices par l'intermédiaire d'une coagulation induite par le substrat sont de nature totalement ou partiellement thermoplastique.

4. Procédé selon la revendication 1, dans lequel les particules conductibles utilisées sont le graphite et/ou le noir de carbone.

5. Procédé selon la revendication 1, dans lequel les agents de mouillage utilisés sont des agents tensioactifs anioniques ou cationiques ou des catalyseurs de transfert de phases.

6. Procédé selon la revendication 1, dans lequel les liaisons métalliques ionogènes utilisées sont des fluorures, des chlorures, des bromures ou des iodures du lithium, du sodium, du potassium, du magnésium, du calcium, du baryum, du strontium, de l'ammonium ou du cuivre.

7. Matériaux composites à bonne conductibilité, fabriqués selon un procédé selon les revendications 1 et 2, caractérisés en ce que les particules rendues conductrices par l'intermédiaire d'une "coagulation induite par le substrat" sont, à la suite de la mise en forme, métallisées par des procédés réducteurs galvaniques ou chimiques.
